Europäisches Patentamt

European Patent Office

Office européen des brevets

(11) Numéro de publication: **0 091 332**
**B1**

(12) **FASCICULE DE BREVET EUROPÉEN**

(45) Date de publication du fascicule du brevet:
23.07.86

(51) Int. Cl.⁴: **H 03 K 17/28, H 03 K 17/60**

(21) Numéro de dépôt: 83400513.4

(22) Date de dépôt: 14.03.83

(54) Circuit temporisateur à sécurité intrinsèque.

(30) Priorité: 02.04.82 FR 8205707

(43) Date de publication de la demande:
12.10.83 Bulletin 83/41

(45) Mention de la délivrance du brevet:
23.07.86 Bulletin 86/30

(84) Etats contractants désignés:
BE DE FR GB IT NL

(56) Documents cité:
FR-A-2 277 426
FR-A-2 325 247
US-A-4 126 795

(73) Titulaire: JEUMONT- SCHNEIDER Société
anonyme dite:, 31- 32, Quai de Dion Bouton,
F-92811 Puteaux Cedex (FR)

(72) Inventeur: Camus, Etienne, 23, Allée des Acacias,
Avilly St- Leonard F-60300 Senlis (FR)

(74) Mandataire: Lejet, Christian, Société JEUMONT-
SCHNEIDER 31- 32, Quai de Dion Bouton, F-92811
Puteaux Cedex (FR)

LIBER, STOCKHOLM 1986

## Description

La présente invention concerne les circuits temporisateurs à sécurité intrinsèque tels que ceux utilisés dans le domaine ferroviaire notamment pour permettre la distinction entre un train rapide et un train lent se présentant à un passage à niveau ou, dans les circuits de voie, ceux destinés à éliminer les défauts transitoires de la valeur de la résistance de shunt entre les deux files de voie.

Ces circuits temporisateurs doivent absolument présenter la particularité de délivrer un signal de sortie après un temps déterminé minimal en réponse à un signal d'entrée, ce temps minimal ne pouvant être réduit même en cas de mauvais fonctionnement de l'un des composants à cause des problèmes de sécurite, la défaillance de l'un des composants ne pouvant avoir pour effet que d'augmenter le retard appliqué au signal de sortie.

Un tel circuit a déjà été décrit par exemple dans le brevet français 2 277 426 selon lequel il comprend un générateur d'impulsions commandant fermeture d'un premier interrupteur et un condensateur chargé par l'intermédiaire d'une première résistance dont la première extrémité est reliée à la borne d'entrée du générateur et disposée en parallèle avec le premier interrupteur et l'enroulement primaire d'un transformateur reliés en série. Le signal prélevé aux bornes de l'enroulement secondaire de ce transformateur commande la fermeture d'un second interrupteur lorsqu'il atteint une valeur suffisante.

Un tel circuit, bien que donnant satisfaction, présente l'inconvénient de ne pas être à sécurité intrinsèque totale dans le sens indiqué précedemment puisqu'une défaillance du transistor consitutant le second interrupteur peut avoir pour conséquence une réduction du retard, ce qui est contraire à la sécurite.

La présente invention a pour but d'obvier à cet inconvénient de telle manière que de toute défaillance de l'un quelconque des composants du circuit conforme à l'invention résulte une augmentation de la temporisation.

Selon l'invention, le second interrupteur est disposé en série entre la première extrémité d'une seconde résistance dont la seconde extrémité est reliée à la borne d'entrée du générateur d'impulsions et une diode Zener reliée à la masse, la première résistance ayant sa seconde extrémité reliée au point de jonction du second interrupteur et de la diode Zener, lequel point de jonction est relié au point de jonction de l'enroulement primaire du transformateur et du condensateur par l'intermédiaire d'une troisième résistance, les impulsions retardées étant prélevées à la première extrémité de la seconde résistance.

L'Homme de l'Art peut alors aisément constater que la défaillance de l'un quelconque des composants entraîne une augmentation de la temporisation.

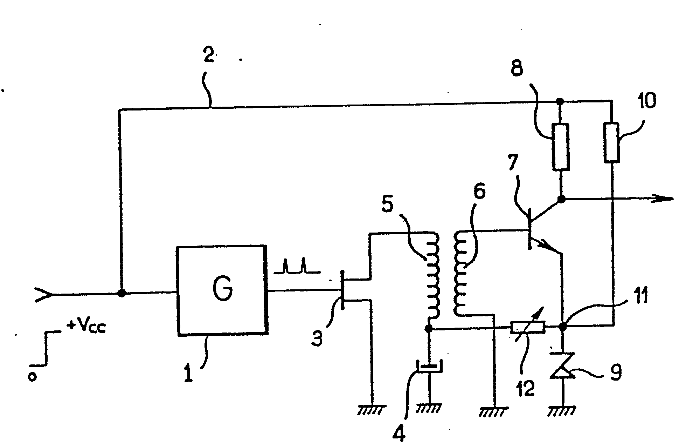

L'invention sera mieux comprise et d'autres buts, avantages et caractéristiques de celle-ci apparaîtront plus clairement à la lecture de la description qui suit d'un mode de réalisation donné à titre non limitatif et à laquelle est annexé un dessin. La figure unique représente schématiquement un circuit temporisateur conforme à la présente invention.

En référence maintenant plus particulièrement à cette figure unique, le signal d'entrée du circuit est uı échelon en tension continue qui est appliqué à la borne d'entrée d'un générateur l d'impulsions. Ce générateur est généralement constitué par une horloge à laquelle est connecté un diviseur de fréquence.

Le conducteur 2 permet d'alimenter le circuit au moyen de l'échelon en tension appliqué à l'entrée et, de ce fait, de n'alimenter le circuit que lorsque cela es nécessaire.

La borne de sortie du générateur 1 est connectée à la grille d'un transistor à effet de champ 3 faisant office d'interrupteur pour le circuit de décharge du condensateur. 4. Le générateur délivre par exemple des impulsions d'une durée de 3μs toutes les 2ms.

Le condensateur 4 est disposé en parallèle avec le drain et la source du transistor 3 et l'enroulement primaire 5 d'un transformateur connectés en série de telle manière que, lorsqu'une impulsation se présente sur la grille du transistor 3, ce dernier devient passant et que le condensateur 4 se décharge dans le circuit. Toutefois, en choisissant des impulsions d'une durée suffisamment courte, le condensateur 4 ne se décharge que partiellement dans le circuit.

Cette impulsion de décharge est transmise au circu de seuil par l'intermédiare de l'enroulement secondaire 6 du transformateur, lequel est relié à la base d'un transistor 7 dont le collecteur est relié au conducteur 2 par l'intermédiaire d'une résistance 8, tandis que l'émetteur de ce transistor est relié à une diode Zener 9 connectée à la masse.

Une résistance 10 relie le conducteur 2 au point de jonction 11 entre le transistor 7 et la diode Zener 9. Une résistance, par exemple variable, 12 relie le point de jonction 11 au point de jonction du condensateur 4 et de l'enroulement primaire 5 du transformateur.

Le fonctionnement du circuit temporisateur est le suivant. Lorsqu'un échelon de tension est appliqué à lı borne d'entrée du générateur 1, une tension déterminée de référence apparait au point de jonction 11 de la diode Zener 9 et de l'émetteur de transistor 7. Cette tension peut d'ailleurs être utilisée pour alimenter en tension continue le générateur d'impulsions 1. Ce dernier délivre, comme indiqué précédemment, des impulsions dont le rôle est de fermer l'interrupteur constitué par le transistor à effet de champ 3 pour provoquer la décharge partielle du condensateur 4 pendant la durée de chaque impulsion. Entre deux impulsions, le transistor 3 constitue un circuit ouvert et le condensateur 4 qui n'était préalablement pas chargé se charge par l'intermédiaire des résistances 10 et 12 avec une constante de temps fonction de la valeur de ces composants.

Lors de la décharge partielle du condensateur 4 dans l'enroulement primaire 5, un signal apparaît aux bornes de l'enroulement secondaire 6 et lorsque ce signal atteint une valeur suffisante fonction de la charge du condensateur 4 et de la chute de potentiel dans la jonction base émetteur du transistor 7, ce dernier devient passant, la tension de référence apparaissant alors sur le collecteur du transistor 7 tant que ce dernier reste passant.

On constate donc que cette tension apparaît sur la collecteur avec un retard déterminé qui est fonction dε

la valeur des résistances 10—12 et du condensateur 4 et, en pratique, du réglage choisi de la résistance variable 12.

On peut dire que ce circuit est à sécurité intrinsèque car la défaillance de l'un quelconque des composants entraîne une augmentation de la temporisation.

En effet, si la diode Zener 9 se coupe, la tension de référence au point 11 s'élève sensiblement à la valeur de la tension du conducteur 2 et le transistor 7 ne peut plus devenir passant du fait de la trop faible différence de tension entre son émetteur et son collecteur. Si au contraire la diode Zener 9 présente une fuite et devient passante, la tension de référence au point 11 diminue et, de ce fait, le condensateur 4 se charge moins vite.

Si le transistor 7 présente une fuite entre deux de ses jonctions, la tension de référence au point 11 est modifiée dans un sens ou dans l'autre ce qui provoque, comme indiqué dans le paragraphe précédent, une augmentation de la temporisation.

La sortie d'un tel circuit temporisateur est généralement connectée à un générateur de tension négative polarisant un transistor faisant fonction de porte de sécurité pour un signal de haute fréquence qui lui est appliqué. Un transformateur disposé à la sortie de ce transistor permet d'assurer l'isolement galvanique du circuit. Sur son enroulement secondaire, on recueille un signal qui, une fois redressé et amplifié, est utilisé pour commander le contact mobile d'un relais.

## Revendication

1. Circuit temporisateur à sécurité intrinsèque délivrant une série d'impulsions dont la première est retardée d'un temps minimal déterminé en réponse à un échelon en tension continue qui lui est appliqué en entrée, et comprenant un générateur d'impulsions (1) délivrant, dès l'application dudit échelon sur sa borne d'entrée, des impulsions commandant la fermeture d'un premier interrupteur (3), et un condensateur (4) chargé par l'intermédiaire d'une première résistance (10) dont la première extrémité est reliée à la borne d'entrée dudit générateur (1) et disposé en parallèle avec ledit premier interrupteur (3) et l'enroulement primaire (5) d'un transformateur reliés en série, le signal prélevé aux bornes de l'enroulement secondaire (6) de ce transformateur commandant la fermeture d'un second interrupteur (7) lorsqu'il atteint une valeur suffisante, ledit circuit étant caractérisé en ce que, ledit second interrupteur (7) est disposé en série entre la première extrémité d'une seconde résistance (8) dont la seconde extrémité est reliée à la borne d'entrée dudit générateur (1) et une diode Zener (9) reliée à la masse, ladite première résistance (10) ayant sa seconde extrémité reliée au point de jonction (11) dudit second interrupteur (7) et de ladite diode Zener (9), lequel point (11) est relié au point de jonction dudit enroulement primaire (5) et dudit condensateur (4) par l'intermédiare d'une troisième résistance (12), les impulsions retardées étant prévlevées à la première extrémité de ladite seconde résistance (8).

## Patentanspruch

Fehlersichere Zeitgeberschaltung, die eine Reihe von Impulsen abgibt, wovon der erste um eine minimale Zeit verzögert wird, die ansprechend auf eine eingangsseitig daran angelegte Gleichspannungsstufe bestimmt wird, versehen mit einem Impulsgenerator (1), der mit dem Anlegen der genannten Stufe an seinen Eingangsanschluß Impulse abgit, welche das Schließen eines ersten Unterbrechers (3) steuern, und mit einem Kondensator (4), der über einen ersten, mit seinem ersten Ende an den Eingangsanschluß des genannten Generators (1) angeschlossenen Widerstand (10) aufgeladen wird und parallel zu der Reihenschaltung aus dem genannten ersten Underbrecher (3) und der Primärwicklung (5) eines Transformators angeordnet ist, wobei das an den Anschlüssen der Sekundärwicklung (6) dieses Transformators abgegriffene Signal das Schließen eines zweiten Unterbrechers (7) steuert, wenn es einen ausreichenden Wert erreicht, wobei die genannte Schaltung dadurch gekennzeichnet ist, daß der genannte zweite Unterbrecher (7) in Reihe zwischen das erste Ende eines zweiten Widerstandes (8), dessen zweites Ende mit dem Eingangsanschluß des genannten Generators (1) verbunden ist, und eine mit Masse verbundene Zenerdiode (9) geschaltet ist, wobei der genannte erste Widerstand (10) an seinem zweiten Ende mit dem Verbindungspunkt (11) zwischen dem zweiten Unterbrecher (7) und der genannten Zenerdiode (9) verbunden ist, welcher Punkt (11) mit dem Verbindungspunkt zwischen der genannten Primärwicklung (5) und dem genannten Kondensator (4) über einen dritten Widerstand (12) verbunden ist, wobei die verzögeten Impulse an dem ersten Ende des genannten zweiten Widerstandes (8) abgegriffen werden.

## Claim

Fail-safe timing circuit delivering a series of pulses the first of which is delayed by a minimum determined in response to a D.C. voltage level applied thereto as input, and comprising a pulse generator (1) delivering, from the application of the said level to its input terminals onwards, pulses which control the closing of a first switch (3), and a capacitor (4) charged through a first resistor (10) whose first end is connected to the input terminal of the said generator (1), said capacitor being arranged in parallel with the said first switch (3) and the primary winding (5) of a transformer which are connected in series, the signal taken at the terminals of the secondary winding (6) of the said transformer controlling the closing of a second switch (7) when it reaches a sufficient value, the said circuit being characterised in that the said second switch (7) is arranged in series between the first end of a second resistor (8) the second end of which is connected to the input terminal of the said generator (1) and a Zenor diode (9) connected to earth, the said first resistor (10) having its second end connected to the junction point (11) of the said second switch (7) and the said Zener diode (9), which point (11) is connected to the junction point of the said primary winding (5) and of the said capacitor (4) via a third resistor (12), the delayed pulses being taken from the first end of the said second resistor (8).